# FASCICULE DE BREVET EUROPEEN

(11) **EP 1 457 784 B1**
(45) Date de publication et mention de la délivrance du brevet: **12.12.2007**
(21) Numéro de dépôt: 04290623.0
(22) Date de dépôt: 08.03.2004
(51) Int. Cl.: G01R 22/00, G01K 17/06

(54) **Indicateur de consommation à efficacité améliorée**
Verbrauchsanzeige mit verbesserter Effizienz
Consumption indicator having improved efficiency

(30) Priorité: 10.03.2003 FR 0302915
(43) Date de publication de la demande: 15.09.2004
(73) Titulaire: Electricité de France, 75008 Paris (FR)
(72) Inventeur: Mellier, Jean, 77360 Vaires-sur-Marne (FR)
(74) Mandataire: Le Forestier, Eric

(56) Documents cités:
- WO-A-99/23455
- US-A- 3 998 093
- US-A- 4 253 151
- US-A- 4 570 226
- US-A- 6 122 603

## Description

L'invention concerne les dispositifs d'affichage de consommation de ressources, qu'il s'agisse de ressources énergétiques (électricité, gaz) ou de matériaux consommables divers (eau chaude, eau froide). L'invention concerne aussi bien le domaine domestique, c'est-à-dire l'habitation, que le domaine industriel ou tertiaire pour des usages comme le chauffage, la climatisation, l'eau froide ou chaude sanitaire, ou encore la production de froid.

En d'autres termes, il s'agit ici de présenter à un utilisateur un état de sa consommation en électricité, en eau ou en gaz, ou en toute autre ressource selon un mode particulier qui suscite chez lui un prise en compte rapide et efficace de l'évaluation des quantités consommées et par là des finances engagées.

Dans ce cadre, on a proposé plusieurs dispositifs parmi lesquels on citera ici les dispositifs particulièrement précis dans leurs indications, sous la forme notamment des compteurs électriques habituels, éventuellement munis d'une pièce rotative illustrant le flux en présence à l'instant de la consultation.

Une autre catégorie, qui se rapproche plus particulièrement de l'objet de la présente invention, regroupe les dispositifs dont le but est, plus spécifiquement, d'afficher par symbolisation géométrique et donc de manière particulièrement efficace, un état global de la situation, afin de susciter chez l'utilisateur une idée concrète dès le premier regard.

On a ainsi proposé, dans le document WO 99/23 455, un dispositif d'affichage sous la forme d'une jauge de consommation, par analogie aux mesures de niveau réalisées dans des cuves.

Ce dispositif comporte une série de diodes illuminées les unes après les autres au fur et à mesure de la progression de la consommation sur la période. L'utilisateur repère facilement la progression de la consommation écoulée.

Pour une évaluation à la fois exacte et précise, particulièrement aisée à la lecture, on veille à ce que la moitié des diodes de la série corresponde à une consommation typique sur la période donnée.

Ainsi, lorsque la moitié des diodes est d'ores et déjà allumée alors que la période n'est pas terminée, l'utilisateur constate immédiatement que sa consommation est particulièrement intense. Cette prise de conscience l'incite à réduire sa consommation, c'est pourquoi ce dispositif se veut incitatif en termes d'économie d'énergie.

Un marquage suggestif est d'ailleurs adopté, dans lequel l'indication « 100 % » est placée justement à l'endroit du dépassement synonyme de gourmandise énergétique.

Un tel dispositif reste toutefois assez rudimentaire. En effet, l'information concrète n'est délivrée qu'au dépassement du seuil pré-évalué de sorte que l'utilisateur ne peut prendre des résolutions d'économie qu'après le dépassement, c'est-à-dire trop tard. En deçà, une comparaison avec la consommation habituelle lui est inaccessible.

Le document US 4,253,151 divulgue un appareil prévu pour surveiller et contrôler une consommation d'énergie électrique, qui mesure et affiche le taux et la consommation électrique totale accumulée par le système, et qui émet un signal lorsque la consommation moyenne journalière dépasse un seuil prédéterminé par l'utilisateur.

Enfin, le document US 3,998,093 présente un dispositif selon le préambule de la revendication 1.

L'invention se propose de fournir une solution pour un dispositif d'affichage de consommation, dans lequel la signification de l'affichage en termes de dépassement passé ou à venir apparaît dès le premier regard à l'utilisateur et dès le début de la période de suivi.

Ce but est atteint conformément à la présente invention grâce à un dispositif d'affichage de consommation selon la revendication 1.

D'autres caractéristiques, buts et avantages de l'invention apparaîtront à la lecture de la description détaillée qui va suivre, faite en référence aux figures annexées sur lesquelles :
- La figure 1 est une vue de face d'un dispositif d'affichage conforme à une première variante de l'invention ;
- La figure 2 est un diagramme de réalisation fonctionnelle de ce dispositif d'affichage ;
- La figure 3 est une vue de face d'un dispositif d'affichage selon l'invention, conforme à une seconde variante.

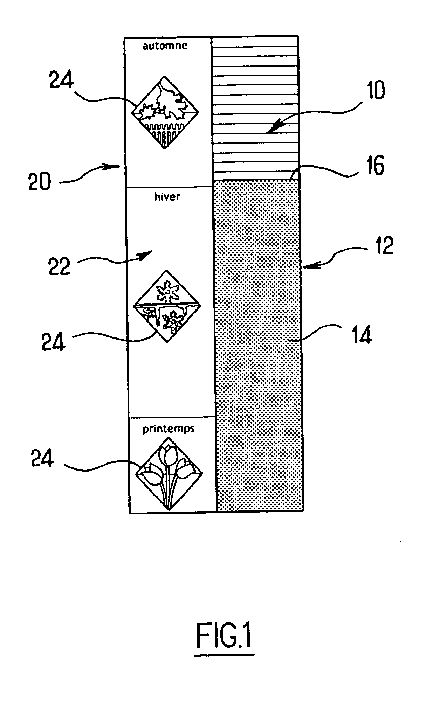

Le dispositif de la figure 1 présente une partie principale d'affichage séparée en deux parties longitudinales et parallèles 10 et 20.

La partie de droite 10 est constituée d'un écran 12 de type à cristaux liquides (LCD) formant zone de progression de la consommation réelle affichée. Cette zone de progression 12 permet d'afficher, par symbolisme géométrique, la progression effective de la consommation.

De cellules 14 successives sur cette zone 12 sont activables les unes après les autres formant ainsi une jauge d'énergie dont l'activation progressive illustre la progression de la consommation au cours de la période.

L'affichage est ici un décomptage à partir d'un « niveau maximal » correspondant au budget global prédéfini, mettant en oeuvre une descente de ce niveau, à l'image d'un niveau de carburant dans un réservoir. Au fur et à mesure de la consommation, le niveau baisse par désactivation des cellules 14 successives.

Ainsi une bordure supérieure 16 des cellules actives constitue un repère de progression de la consommation réelle.

La partie de gauche, référencée 20, forme, elle, un moyen de repérage de consommation théorique, pour comparaison avec la consommation réelle.

La zone de gauche ne se limite toutefois pas à une simple indication d'un seuil de dépassement donné.

En effet, le présent dispositif d'affichage est doté, à travers cette partie 20, d'une zone de progression 22 de la consommation théorique. Cette zone de progression 22 permet d'afficher une progression préétablie de consommation typique pendant une saison de chauffe.

Le moyen d'affichage de progression théorique 20 consiste donc en une zone de progression 22, munie ici d'un référentiel temporel 24 permettant de se positionner à tout moment sur cette zone. Le référentiel temporel est dimensionné spécifiquement en conformité avec une progression typique des cellules de la jauge réelle 10.

Dans le présent exemple, les indications se présentent ici sous forme de pictogrammes répartis en trois portions correspondant respectivement au printemps, à l'hiver et à l'automne. L'utilisateur, à la date du jour, se positionne sans effort au début de l'automne, au milieu de l'hiver ou la fin du printemps par exemple.

On notera, sur l'exemple de la figure 1, que le référentiel temporel est spécifiquement élaboré à partir d'une progression habituelle.

Ainsi, l'étendue de la progression correspondant à l'hiver est nettement plus élevée que l'étendue correspondant à la consommation du printemps ou de l'automne.

Cette situation illustre la répartition de consommation typique rencontrée en fonction des températures extérieures.

L'étendue du printemps et celle de l'automne sont inférieures à l'étendue de l'hiver (bien que temporellement identiques), car les étendues représentent ici une évolution de quantité consommée et non une évolution temporelle stricte. Le référentiel temporel n'est donc pas linéaire en fonction du temps, mais proportionnelle aux consommations habituelles rencontrées pendant les saisons.

La mise en correspondance côte à côte de ces deux zones de progression, c'est-à-dire du référentiel temporel, constitué de la zone de progression 22 et des moyens de repérage temporel 24, avec la jauge 10, fournit un résultat technique tout à fait avantageux, puisque l'utilisateur compare directement et sans effort la progression de la jauge 10 en regard de la progression théorique telle qu'attendue et indiquée par la zone 22.

En d'autres termes, si l'utilisateur consulte le dispositif le 21 décembre, c'est-à-dire au premier jour de l'hiver, la jauge 10 est censée, en théorie, se trouver en regard de la limite entre automne et hiver, référence de consommation théorique de la zone 22.

Si la zone foncée de la jauge s'avère rester en deçà de la limite entre automne et hiver, cela signifie qu'un nombre de cellules important s'est déjà éclairci, correspondant à une consommation supérieure à celle attendue.

En d'autres termes, la jauge de droite 10 indique une consommation correspondant à une nette progression calendaire dans l'hiver, alors que l'hiver est à peine commencé. L'utilisateur en tire donc un sentiment négatif.

Ici, l'utilisateur sait alors qu'il consomme plus que la normale. A l'inverse, si l'utilisateur se situe au premier tiers de l'hiver, c'est-à-dire au 21 janvier, il peut constater immédiatement si la jauge se situe encore au-dessus de cette date.

Dans les deux exemples d'utilisation donnés ci-dessus, l'utilisateur en tire la conclusion immédiate qu'il consomme plus ou qu'il consomme moins que la progression prévisionnelle indiquée par la zone de progression 22 et ses repères correspondants.

L'utilisateur se situe à tout moment en référence à un référentiel temporel, lui donnant une réponse visuelle immédiate à la question « à quel degré de progression devrait se trouver la jauge en théorie ? ».

Le dispositif proposé ici met donc en parallèle deux moyens d'affichage de progression de consommation, l'un pour une consommation réelle (jauge de consommation), l'autre pour une progression théorique.

L'utilisateur dispose en d'autres termes d'un tableau mettant en concurrence deux progressions, qui s'étalent géométriquement selon la même dimension.

Face à cette « course de consommation » ainsi affichée, l'utilisateur se situe immédiatement en termes de performances ou d'alignement quant à ses économies d'énergie.

Il est prévu en variante une zone supplémentaire de quelques cellules d'affichage sur la jauge 10, correspondant à un dépassement du budget chauffage.

Plusieurs fonctions sont également prévues accessibles à l'utilisateur comme la remise à la date du produit, la saisie de la valeur correspondante au budget prévisionnel, la demande de remise à jour du produit.

On notera que le référentiel temporel de cette première variante est affiché préférentiellement par écran piloté par des moyens électroniques pour possibilité de configuration variable.

On décrira maintenant une autre variante de dispositif mettant en concurrence la progression réelle et une progression temporelle théorique et formant, en d'autres termes, le siège d'une course à l'économie entre une zone de progression 22 pré-établie et une zone de progression 12 en prise directe avec la consommation.

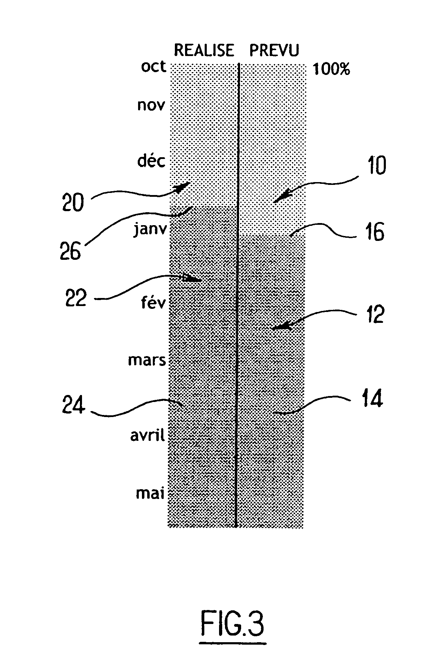

Dans ce second dispositif (figure 3), la mise en correspondance entre progression théorique et progression réelle est réalisée sous la forme de deux jauges semblables à la jauge 10 présentées ci-dessus, une de ces deux jauges étant toutefois pilotée pour afficher une progression théorique de consommation d'énergie.

Ainsi, sur la figure 3, la jauge de gauche est constituée d'une zone de progression 22 portant une série de cellules désactivables 24 , dont la limite supérieure 26 indique le niveau de progression théorique.

Ainsi, selon que la jauge de consommation réelle 10 se situe au-dessus ou au dessous du repère de niveau 26 de la jauge de consommation théorique 20, l'utilisateur tire un sentiment positif ou négatif quant à sa consommation.

Pour la réalisation du référentiel temporel de la première variante ci-dessus, comme pour la programmation de la jauge de consommation théorique de cette seconde variante, le dispositif est préférentiellement configuré à partir de données de consommation connues empiriquement pour des mêmes circonstances de consommation (données météorologiques trentenaires par exemple).

Pour une consommation d'énergie de chauffage, la surface de l'habitation et la qualité de l'isolation thermique sont prises en compte, et, par comparaison avec des données relevées habituellement dans un foyer similaire, la progression théorique de la jauge est facilement établie.

Ici, la quantité d'énergie de chauffage annuel pour le logement est déterminée par un conseiller à distance et communiquée au client. Le budget correspondant est également déterminé et fourni au client.

Le nombre de kWh est indiqué au système par une saisie sur des touches du dispositif, par exemple par valeur « déroulante » à valider, puis pression d'une touche « validation ».

Le produit est présenté ici en une version de base avec une utilisation locale. Une variante consiste en une version communicante par courant porteur en ligne, c'est-à-dire superposition d'un signal d'informations sur un courant d'alimentation énergétique. Cette version permet à un centre de traitement de constater d'éventuels dépassements de consommation à la date considérée et d'avertir l'utilisateur.

La communication peut également être établie du centre de traitement vers le produit afin d'établir un nouveau paramétrage si besoin.

Il est également prévu d'indiquer le coût total prévisionnel sur le dispositif grâce à un affichage ou un marquage (système à clipser par exemple).

Dans le cadre de la jauge à progression pré-programmée (figure 3), les progressions respectives théorique et réelle sont comparées sans prise en compte directe du temps écoulé, c'est-à-dire sans nécessité de connaître la date du jour.

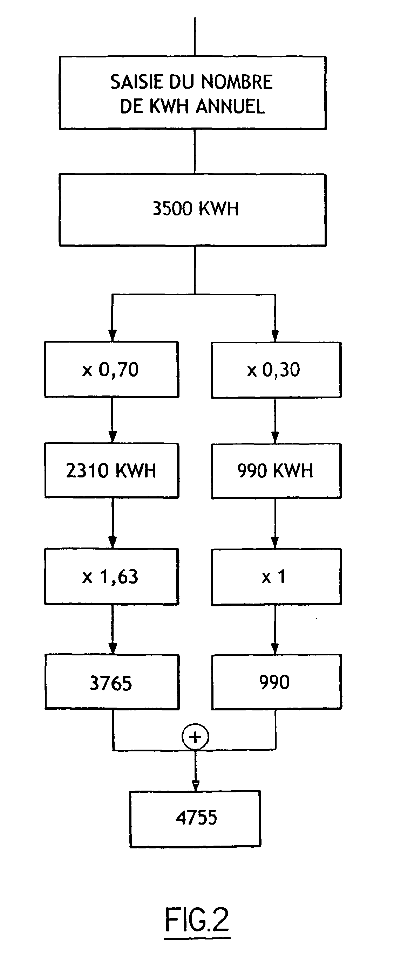

Le dispositif est monté dans un boîtier d'affichage mural et inclut une électronique spécifiquement adaptée pour les fonctions en présence (figure 2).

On notera notamment la présence d'un processeur et de moyens de mémorisation.

Le processeur est apte à traiter un relevé permanent, typiquement impulsionnel et résultant par exemple d'une mesure du flux électrique en présence en entrée de l'habitation concernée. Pour cela, il intègre ce flux et en déduit la consommation écoulée depuis le début de la période.

La mémoire comporte l'ensemble des paramètres nécessaires à ce calcul.

Le mode de réalisation privilégié consiste à fournir une jauge de consommation en termes de coût financier. De la même manière, la consommation théorique affichée est une consommation budgétaire en fonction de l'énergie utilisée.

Dans ce mode de réalisation, le dispositif est prévu (figure 2) pour tenir compte de tarifications différentes au cours d'une journée.

Ainsi, le dispositif est, par exemple, muni d'une horloge utilisée par le micro-processeur pour appliquer, au flux énergétique mesuré, un coefficient financier différent selon qu'on se situe en heures creuses (HC) ou en heures pleines (HP).

Chaque cellule est décomptée à partir du moment ou certaine valeur financière a été consommée et ceci en tenant compte des différents poids des énergies consommées soit en HP ou en HC.

Lorsque l'énergie est consommée en période tarifaire favorable, l'affichage évoluera moins rapidement.

Si l'énergie est consommée en période tarifaire à un coût supérieur, l'utilisateur verra son affichage évoluer plus rapidement.

Le principe de ce décomptage de consommation est maintenant présenté sous forme d'un exemple, en référence à la figure 2.

Prenons l'exemple d'un logement moyen qui aurait un budget prévisionnel de l'ordre de 300 € TTC par an pour le poste chauffage (soit 3000 kWh). Cette prévision est établie entre le client et un Conseiller Electrique à distance.

Considérons que ce budget soit théoriquement réparti de la manière suivante :
- 70 % sont consommés en HP (heures pleines), soit 2310 kWh,
- 30 % sont consommées en HC (heures creuses), soit 990 kWh.

Une différentiation est réalisée entre l'énergie disponible pour les HP et celle disponible pour les HC (afin de tenir compte de la différence des tarifs pratiqués en HP et en HC). Cette différentiation peut être réalisée en attribuant un coefficient aux énergies consommées soit en HP, soit en HC. Ce coefficient est de 1,63.

Soit par exemple :
- 2310 x 1,63 = 3765 points,
- 990 x 1 = 990 points,

Soit au total 4755 points représentant le capital points disponible pour la saison de chauffe (valeurs non accessibles par le client).

Au niveau de l'affichage mis à la disposition du client, le niveau d'énergie est représenté par 50 cellules rendues actives. Une cellule va représenter une énergie de 4755 points / 50 = 95 points.

Dès le premier appel sur le poste de chauffage (entre début septembre et octobre), le capital points va diminuer en fonction des consommations et le décomptage de l'énergie va commencer.

La manière de procéder au décomptage est la suivante :
- lorsque 1 kWh est consommé en HP, 1 * 1,63 = 1,63 points, on déduit 1,63 de 4755 = 4753,37 points,
- lorsque 1 kWh est consommé en HC, 1 * 1 = 1 point, on déduit 1 de 4753,37 il reste 4752,37 points, et ainsi de suite.

L'extinction d'une première cellule d'affichage se produit de la façon suivante :
- Si 70 kWh sont consommés en HP, 70 * 1,63 = 114,1 il reste 4638,37 points,
- si 30 kWh sont consommés en HC, 30 * 1 = 30 il reste 4608,37 points.

Depuis l'initiation du système, 4755 - 4608,37 = 116,63 points sont consommés, soit 1 cellule éteinte puisque 1 cellule équivaut à 95 points.

L'afficheur indique alors un niveau d'énergie disponible inférieur, soit 49 cellules actives. Et ainsi de suite jusqu'à la fin de la saison de chauffe.

On notera que la mesure du flux (du flux d'eau consommée ou du flux de gaz dans d'autres applications) est ici fournie sous la forme d'un signal électrique au présent module d'affichage. Dans une autre variante, c'est le module d'affichage lui-même qui réalise la mesure.

Outre les moyens décrits ci-dessus, le dispositif est préférentiellement muni de moyens permettant de le mettre en fonctionnement aisément en cours de période de mesure.

Ainsi, dans le cas de la première variante, le micro-processeur et la mémoire sont prévus pour mettre en oeuvre un positionnement initial de la jauge 10 en regard direct de la date effective du jour de mise en route sur le référentiel temporel 20.

Si le dispositif d'affichage est implanté au 21 décembre, la jauge est automatiquement positionnée vis-à-vis de la limite entre automne et hiver, correspondant à une consommation théorique qui aurait dû avoir lieu sur la portion de temps écoulée.

Dans la variante à deux jauges parallèles, la jauge réelle est positionnée au même niveau que la jauge théorique pour la date considérée.

Dans ces deux cas, le dispositif inclut pour cela des moyens de mémorisation comportant une table de correspondance entre date et consommation théorique à cette date, qui permettent le pré-positionnement de la jauge de mesure (et de la jauge théorique dans la seconde variante).

Cette fonctionnalité est ici en outre réalisée par la mise en oeuvre d'une table d'allocations avec dates et dureté climatique de chaque jour pour un positionnement très précis sur une échelle de progression représentative de la finance réelle engagée

Ainsi, dans les deux cas, les écarts entre jauge réelle et indicateur de progression théorique sont initialement nuls et n'apparaissent qu'après une certaine durée de fonctionnement du dispositif.

## Revendications

1. Dispositif d'affichage de consommation de ressource sur une période donnée, comprenant un afficheur (10) de progression de consommation réelle (14,16) qui comprend une zone de progression réelle (12) et un repère de consommation réelle à positionnement variable sur cette zone de progression réelle, le dispositif d'affichage comprenant en outre un moyen de repérage de consommation théorique (20) en regard de la zone de progression réelle (12), permettant de signaler un dépassement de la consommation théorique par la consommation réelle, ce moyen de repérage de consommation théorique (20) consistant en un indicateur de progression théorique de consommation au cours de la période donnée qui se compose lui-même d'une zone de progression théorique (22) et de moyens de positionnement progressif (24, 26) d'un repère de consommation théorique sur cette zone de progression théorique (22), **caractérisé en ce que** la zone de progression théorique de l'indicateur de progression théorique a une étendue correspondant à un niveau maximal correspondant à un budget global prédéfini de consommation sur la période donnée.

2. Dispositif selon la revendication 1, **caractérisé en ce que** la zone de progression théorique (22) du moyen de repérage de consommation théorique (20) inclut des indications (24) formant référentiel temporel sur cette zone de progression (22), ces indications formant lesdits moyens de positionnement progressif (24,26) de repère de consommation théorique.

3. Dispositif selon la revendication 1 ou la revendication 2, **caractérisé en ce qu'**il comporte des moyens pour évaluer un coût financier à partir d'un ou de relevés de consommation de ressource, et piloter la progression du repère de consommation réelle (14, 16) en fonction de cette valeur de coût.

4. Dispositif selon la revendication 3, **caractérisé en ce qu'**il inclut des moyens de conversion pour appliquer un coefficient de conversion sur une mesure de consommation de ressource afin de convertir celle-ci en une indication de coût financier, et **en ce que** ces moyens de conversion sont prévus pour appliquer deux coefficients de conversion différents, selon que la consommation convertie est relevée en période à tarif élevé ou en période à tarif faible.

5. Dispositif selon la revendication 4, **caractérisé en ce que** les moyens de conversion sont constitués par un processeur et des moyens de mémorisation contenant le ou les coefficients de conversion, et **en ce que** les moyens de mémorisation sont prévus pour autoriser une modification du ou des coefficients de conversion.

6. Dispositif selon l'une quelconque des revendications précédentes, **caractérisé en ce qu'**il comporte en outre des moyens de mémorisation comportant une table de correspondance entre dates et consommations théoriques à ces dates et des moyens pour établir sur commande un pré-positionnement du repère de consommation réelle à la valeur correspondant à la date considérée, notamment en cas de démarrage du dispositif à une date située dans la période de mesure.

7. Dispositif selon l'une quelconque des revendications précédentes, **caractérisé en ce qu'**il inclut des moyens de communication avec une centrale à distance.

8. Dispositif selon la revendication 7 en combinaison avec la revendication 5, **caractérisé en ce que** les moyens de communication avec une centrale à distance sont prévus pour autoriser un réglage des coefficients de conversion mémorisés dans le dispositif.

9. Dispositif selon la revendication 7, **caractérisé en ce que** les moyens de communication avec une centrale à distance sont prévus pour transmettre à cette centrale l'état de progression de consommation réelle affiché par le dispositif.

10. Dispositif selon la revendication 1, **caractérisé en ce que** le moyen de repérage de consommation théorique (20) comporte, en tant que la zone de progression théorique (22), une zone constituée d'une série de cellules (24) activées et désactivées électroniquement, le dispositif comportant en outre des moyens de pilotage d'activation ou de désactivation des cellules (24) selon une progression préétablie, une limite formée des cellules (24) spécifiquement activées ou désactivées formant le repère de progression (26) de consommation théorique.

11. Dispositif selon la revendication précédente, **caractérisé en ce qu'**il comprend des moyens de préréglage de progression du repère de progression de consommation théorique (24, 26).

12. Dispositif selon la revendication 11, **caractérisé en ce que** les moyens de préréglage de progression du repère de consommation théorique (24, 26) incluent des moyens de communication avec une centrale à distance, prévus pour autoriser ce préréglage par la centrale à distance.

## Claims

1. Device for displaying the consumption of a resource over a given period, comprising a progression display (10) of actual consumption (14, 16) which comprises an actual progression zone (12) and an actual consumption marker having a variable positioning on this actual progression zone, the display device further comprising means for marking the theoretical consumption (20) opposite the actual progression zone (12), for indicating an overtaking of the theoretical consumption by the actual consumption, the said theoretical consumption marking means (20) consisting of a theoretical consumption progression indicator over the given period, which itself comprises a theoretical progression zone (22) and progressive positioning means (24, 26) of a theoretical consumption marker on this theoretical progression zone (22), **characterized in that** the theoretical progression zone (22) of the theoretical progression indicator has a range corresponding to a maximum level corresponding to a predefined total consumption budget over the given period.

2. Device according to Claim 1, **characterized in that** the theoretical progression zone (22) of the theoretical consumption marking means (20) includes indicators (24) forming a time reference on this progression zone (22), these indications forming the said progressive positioning means (24, 26) of the theoretical consumption marker.

3. Device according to either of Claims 1 and 2, **characterized in that** it comprises means for assessing a financial cost from one or more resource consumption records, and for controlling the progression of the actual consumption marker (14, 16) according to this cost value.

4. Device according to Claim 3, **characterized in that** it includes conversion means for applying a conversion factor to a resource consumption measurement in order to convert the said measurement to a financial cost indication, and **in that** these conversion means are provided to apply two different conversion factors, according to whether the converted consumption is recorded in a high tariff period or in a low tariff period.

5. Device according to Claim 4, **characterized in that** the conversion means consist of a processor and storage means containing the conversion factor(s), and **in that** the storage means are provided to allow a modification of the conversion factor(s).

6. Device according to any one of the preceding claims, **characterized in that** it further comprises storage means comprising a correspondence table between dates and theoretical consumptions at these dates and means for establishing when ordered a prepositioning of the actual consumption marker at the value corresponding to the date concerned, particularly in case of startup of the device at a date falling within the measurement period.

7. Device according to any one of the preceding claims, **characterized in that** it includes means for communicating with a remote central processor.

8. Device according to Claim 7 in combination with Claim 5, **characterized in that** the means for communicating with a remote central processor are provided to allow an adjustment of the conversion factors stored in the device.

9. Device according to Claim 7, **characterized in that** the means for communicating with a remote central processor are provided to transmit to the said processor the state of the progress of the actual consumption displayed by the device.

10. Device according to Claim 1, **characterized in that** the theoretical consumption marking means (20) comprise, as theoretical progression zone (22), a zone consisting of a series of cells (24) electronically activated and deactivated, the device further comprising control means for activating or deactivating the cells (24) according to a predefined progression, a limit formed of the cells (24) specifically activated or deactivated forming the theoretical consumption progression marker (26).

11. Device according to the preceding claim, **characterized in that** it comprises means for preadjusting the progression of the theoretical consumption progression marker (24, 26).

12. Device according to Claim 11, **characterized in that** the means for preadjusting the progression of the theoretical consumption marker (24, 26) include means for communicating with a remote central processor, provided to authorize the preadjustment by the remote central processor.

## Patentansprüche

1. Vorrichtung zur Anzeige des Verbrauchs einer Ressource über eine gegebene Zeitdauer, welche einen Fortschrittsanzeiger (10) eines tatsächlichen Verbrauchs (14, 16) umfasst, der einen Bereich tatsächlichen Fortschreitens (12) und eine Markierung tatsächlichen Verbrauchs mit variabler Positionierung auf diesem Bereich tatsächlichen Fortschreitens umfasst, wobei die Anzeigevorrichtung außerdem ein Mittel zur Markierung theoretischen Verbrauchs (20) in Bezug auf den Bereich tatsächlichen Fortschreitens (12) umfasst, das erlaubt, ein Überschreiten des theoretischen Verbrauchs durch den tatsächlichen Verbrauch zu signalisieren, wobei dieses Mittel zur Markierung theoretischen Verbrauchs (20) aus einem Indikator theoretischen Fortschreitens eines Verbrauchs im Laufe der gegebenen Zeitdauer besteht, der sich selbst aus einem Bereich theoretischen Fortschreitens (22) und Mittel zur fortschreitenden Positionierung (24, 26) einer Markierung theoretischen Verbrauchs auf diesem Bereich theoretischen Fortschreitens (22) zusammensetzt, **dadurch gekennzeichnet, dass**
der Bereich theoretischen Fortschreitens (22) des Indikators theoretischen Fortschreitens eine Ausdehnung hat, die einem maximalen Niveau entspricht, das einem globalen vorbestimmten Verbrauchsbudget über der gegebenen Zeitdauer entspricht.

2. Vorrichtung gemäß Anspruch 1, **dadurch gekennzeichnet, dass** der Bereich theoretischen Fortschreitens (22) des Markierungsmittels theoretischen Verbrauchs (20) Angaben (24) umfasst, die ein Zeitbezugssystem auf diesem Bereich des Fortschreitens (22) bilden, wobei diese Angaben die Mittel fortschreitender Positionierung (24, 26) der Markierung theoretischen Verbrauchs bilden.

3. Vorrichtung gemäß Anspruch 1 oder 2, **dadurch gekennzeichnet, dass** sie Mittel umfasst, um einen finanziellen Kostenpunkt aus einer oder mehreren Ressourcenverbrauchsaufstellung(en) auszuwerten und das Fortschreiten der Markierung tatsächlichen Verbrauchs (14,16) in Abhängigkeit dieses Kostenpunktwerts zu steuern.

4. Vorrichtung gemäß Anspruch 3, **dadurch gekennzeichnet, dass** sie Konversionsmittel umfasst, um einen Konversionskoeffizienten auf einer Ressourcenverbrauchsmessung anzuwenden, um diese in eine Angabe eines finanziellen Kostenpunkts zu konvertieren, und **dadurch, dass** diese Konversionsmittel vorgesehen sind, um zwei verschiedene Konversionskoeffizienten anzuwenden, gemäß derer der konvertierte Verbrauch in einem Zeitraum mit erhöhtem Tarif oder in einem Zeitraum mit niedrigem Tarif festgestellt wird.

5. Vorrichtung gemäß Anspruch 4, **dadurch gekennzeichnet, dass** die Konversionsmittel aus einem Prozessor und Speichermittel gebildet sind, die den oder die Konversionskoeffizienten enthalten und **dadurch, dass** die Speichermittel vorgesehen sind, um eine Modifikation des oder der Konversionskoeffizienten zu erlauben.

6. Vorrichtung gemäß einem der vorhergehenden Ansprüche, **dadurch gekennzeichnet, dass** sie außerdem Speichermittel umfasst, die eine Korrespondenztabelle zwischen Datumsangaben und theoretischen Verbrauchen zu diesen Datumsangaben und Mittel zum Einrichten auf Befehl einer Vorabpositionierung der Markierung tatsächlichen Verbrauchs auf den der betrachteten Datumsangabe entsprechenden Wert umfassen, insbesondere im Fall des Anlaufens der Vorrichtung zu einem im Messzeitraum gelegenen Datum.

7. Vorrichtung gemäß einem der vorhergehenden Ansprüche, **dadurch gekennzeichnet, dass** sie Mittel zur Kommunikation mit einer entfernten Zentrale umfasst.

8. Vorrichtung gemäß Anspruch 7 in Kombination mit Anspruch 5, **dadurch gekennzeichnet, dass** die Mittel zur Kommunikation mit einer entfernten Zentrale vorgesehen sind, um ein Einstellen der in der Vorrichtung gespeicherten Konversionskoeffizienten zu erlauben.

9. Vorrichtung gemäß Anspruch 7, **dadurch gekennzeichnet, dass** die Mittel zur Kommunikation mit einer entfernten Zentrale vorgesehen sind, um zu dieser Zentrale den Zustand des Fortschreitens eines tatsächlichen Verbrauchs zu übertragen, der von der Vorrichtung angezeigt wird.

10. Vorrichtung gemäß Anspruch 1, **dadurch gekennzeichnet, dass** das Mittel zur Markierung theoretischen Verbrauchs (20) als den Bereich theoretischen Fortschreitens (22) einen Bereich umfasst, der aus einer Reihe elektronisch aktivierter und deaktivierter Zellen (24) gebildet ist, wobei die Vorrichtung außerdem Mittel zur Steuerung der Aktivierung oder Deaktivierung der Zellen (24) gemäß einem vorher erstellten Fortschreiten umfasst, wobei eine aus spezifisch aktivierten oder deaktivierten Zellen (24) gebildete Grenze die Markierung des Fortschreitens (26) theoretischen Verbrauchs bildet.

11. Vorrichtung gemäß dem vorhergehenden Anspruch, **dadurch gekennzeichnet, dass** sie Mittel zur Voreinstellung des Fortschreitens der Markierung des Fortschreitens theoretischen Verbrauchs (24, 26) umfasst.

12. Vorrichtung gemäß Anspruch 11, **dadurch gekennzeichnet, dass** die Mittel zur Voreinstellung des Fortschreitens der Markierung theoretischen Verbrauchs (24,26) Mittel zur Kommunikation mit einer entfernten Zentrale umfassen, die vorgesehen sind, um diese voreinstellung durch die entfernte Zentrale zu erlauben.
